# EUROPÄISCHE PATENTSCHRIFT

(11) **EP 3 793 221 B1**
(45) Veröffentlichungstag und Bekanntmachung des Hinweises auf die Patenterteilung: **24.09.2025**
(21) Anmeldenummer: 20195530.9
(22) Anmeldetag: 10.09.2020
(51) Int. Cl.: H04R 31/00

(54) **VERFAHREN ZUM HERSTELLEN EINER WANDLEREINHEIT**
METHOD FOR MANUFACTURING A TRANSDUCER UNIT
PROCÉDÉ DE FABRICATION D'UNE UNITÉ TRANSDUCTEUR

(30) Priorität: 12.09.2019 DE 102019124595
(43) Veröffentlichungstag der Anmeldung: 17.03.2021
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); RENAUD-BEZOT, Nick, 1050 Wien (AT)
(74) Vertreter: Canzler & Bergmeier Patentanwälte Partnerschaft mbB

(56) Entgegenhaltungen:
- WO-A1-2005/075953
- WO-A1-2018/148485
- JP-A- S 513 218
- US-A- 6 087 760
- US-A1- 2003 107 300
- US-A1- 2011 064 250
- US-A1- 2014 270 325
- JUST E ET AL: "A membrane actuator based on piezo-polymer-composite technology", TRANSDUCERS '05 : THE 13TH INTERNATIONAL CONFERENCE ON SOLID-STATE SENSORS, ACTUATORS AND MICROSYSTEMS ; SEOUL, KOREA, [JUNE 5 - 9, 2005] ; DIGEST OF TECHNICAL PAPERS, IEEE OPERATIONS CENTER, PISCATAWAY, NJ, vol. 1, 5 June 2005 (2005-06-05), pages 753 - 756, XP010828265, ISBN: 978-0-7803-8994-6, DOI: 10.1109/SENSOR.2005.1496526

## Beschreibung

Die vorliegende Erfindung betrifft ein Verfahren zum Herstellen einer Wandlereinheit, insbesondere einer MEMS-Wandlereinheit, zum Wandeln von elektrischen Signalen in Auslenkungen und/oder von Auslenkungen in elektrische Signale, bei dem auf einem Trägerelement zumindest ein Wandlerelement angeordnet wird, und das Wandlerelement mit einer entlang einer Hubachse auslenkbaren Membraneinheit gekoppelt wird. Ferner betrifft die Erfindung eine Wandlereinheit.

Aus der DE 603 13 715 T2 ist ein Verfahren zum Herstellen einer Wandlereinheit bekannt. Dies erfolgt dadurch, dass eine Opferschicht auf ein Substrat aufgebracht wird. Danach wird aufeinanderfolgend eine Membranschicht, eine untere Elektrodenschicht, eine aktive Schicht und eine obere Elektrodenschicht aufgebracht. Nachteilig daran ist, dass das Herstellungsverfahren aufwändig ist.

Der Artikel Just E et al: "A membrane actuator based on piezo-polymer-composite technology",TRANSDUCERS '05 : THE 13TH INTERNATIONAL CONFERENCE ON SOLID-STATE SENSORS, ACTUATORS AND MICROSYSTEMS ; SEOUL, KOREA, [JUNE 5 - 9, 2005] ; DIGEST OF TECHNICAL PAPERS, IEEE OPERATIONS CENTER, PISCATAWAY, NJ, Bd. 1, 5. Juni 2005 (2005-06-05), Seiten 753-756, DOI: 10.1109/SENSOR.2005.1496526, ISBN: 978-0-7803-8994-6 beschreibt ein Herstellungsverfahren für eine MEMS-Wandlereinheit, bei der eine Polymer-Membran an eine piezoelektrisches Scheibe angegossen wird.

Aufgabe der vorliegenden Erfindung ist es, ein flexibles Herstellungsverfahren für eine Wandlereinheit zu schaffen.

Die Aufgabe wird gelöst durch ein Verfahren zum Herstellen einer Wandlereinheit und eine Wandlereinheit mit den Merkmalen der unabhängigen Patentansprüche.

Vorgeschlagen wird ein Verfahren zum Herstellen einer Wandlereinheit zum Wandeln von elektrischen Signalen in Auslenkungen und/oder von Auslenkungen in elektrische Signale. Die Wandlereinheit kann eine MEMS-Wandlereinheit sein, welche einen Piezoaktor umfasst. In einer Anwendung kann die Wandlereinheit zum Erzeugen und/oder Erfassen von Schallwellen im hörbaren Wellenlängenbereich und/oder im Ultraschallbereich verwendet werden. Die elektrischen Signale können bei dieser Anwendung Audiosignale sein, welche in Auslenkungen, welche wiederum Schallwellen erzeugen, gewandelt werden. Die Wandlereinheit kann somit ein Lautsprecher und/oder ein Mikrofon sein. Als Mikrofon wandelt die Wandlereinheit die Auslenkungen, welche von Schallwellen herrühren, in das elektrische Signal bzw. das Audiosignal um. Die Wandlereinheit ist ein MEMS-Schallwandler. Wenn Schallwellen im Ultraschallbereich erzeugt und/oder erfasst werden, können diese beispielsweise für technische Prüfgeräte oder in Ultraschallgeräten für Sonografie verwendet werden.

Die Wandlereinheit kann zusätzlich oder alternativ auch als Aktor verwendet werden, wobei mittels der Auslenkung beispielsweise ein Druck oder eine Kraft erzeugt wird. Weiterhin kann die Wandlereinheit auch als ein Sensor verwendet werden, wenn ein Vorgang eine Auslenkung, beispielsweise wiederum ein Druck oder eine Kraft, hervorruft, welche dann durch die Wandlereinheit in ein elektrisches Signal umgesetzt wird.

Beim Verfahren wird auf einem Trägerelement zumindest ein Wandlerelement angeordnet. Das Trägerelement kann beispielsweise ein Trägersubstrat sein. Auf dem Trägerelement ist somit das zumindest eine Wandlerelement zum Erzeugen und/oder Erfassen der Schallwellen angeordnet. Das Wandlerelement kann das elektrische Signal bzw. eine elektrische Spannung in eine Auslenkung umwandeln, so dass dadurch beispielsweise die Schallwellen erzeugt werden können. Das Wandlerelement kann aber auch die Auslenkungen in das elektrische Signal bzw. die elektrische Spannung umsetzen, so dass dadurch beispielsweise die Schallwellen erfasst werden können. Das Trägerelement kann beispielsweise eine Leiterplatte sein und/oder elektrische Leitungen für das Wandlerelement umfassen.

Des Weiteren wird das Wandlerelement mit einer entlang einer Hubachse auslenkbaren Membraneinheit gekoppelt. Mittels der Kopplung können die Auslenkungen zwischen der Membraneinheit und dem zumindest einen Wandlerelement ausgetauscht werden. Das Wandlerelement kann beispielsweise zum Erzeugen der Schallwellen die Membraneinheit gemäß einem elektrischen Signal auslenken bzw. mit Schwingungen beaufschlagen, so dass die Membraneinheit die darüber angeordnete Luft ebenfalls zum Schwingen anregt, so dass die Schallwellen erzeugt werden. Dagegen kann die durch die Schallwellen schwingende Luft die Membraneinheit ebenfalls zum Schwingen anregen, was wiederum auf das Wandlerelement übertragen wird. Das Wandlerelement setzt die Schwingungen in ein elektrisches Signal, also das Audiosignal, um.

Erfindungsgemäß wird zur Ausbildung zumindest eines flexiblen Membranelements ein fließfähiges und aushärtbares Membranmaterial zumindest abschnittsweise an ein mit dem Wandlerelement gekoppeltes Verstärkungselement der Membraneinheit angegossen. Das Membranelement und das Verstärkungselement bilden zusammen zumindest teilweise die Membraneinheit aus.

Das Membranmaterial kann beispielsweise ein Polymer sein. Ferner kann das Membranmaterial ein Silikon sein. Das Membranmaterial kann ein Thermoplast, Elastomer oder Duroplast sein. Da das Membranelement flexibel ist, kann es zusammen mit dem Verstärkungselement ausgelenkt werden, so dass die Membraneinheit ausgelenkt werden kann. Das Verstärkungselement kann selbst flexibel sein, weist jedoch eine geringere Flexibilität als das zumindest eine Membranelement auf. Eine Steifigkeit des Verstärkungselements ist höher als die des Membranelements. Das Verstärkungselement kann aber auch steif sein. Infolgedessen krümmt oder verbiegt sich lediglich das zumindest eine Membranelement, wenn die Membraneinheit ausgelenkt wird.

Durch das Angießen des zumindest einen Membranelements an das Verstärkungselement kann das Herstellungsverfahren vereinfacht werden. Außerdem ist dadurch ein flexibles Herstellungsverfahren geschaffen, da durch das Angießen des fließfähigen Membranmaterials auf jede Form der Wandlereinheit und/oder des Verstärkungselements eingegangen werden kann. Auf ein vorheriges Anpassen der Membraneinheit auf verschiedene Formen der Wandlereinheit kann damit verzichtet werden.

Von der Flexibilität des Membranelements hängen auch die akustischen Eigenschaften der Wandlereinheit ab, wenn diese als Schallwandler verwendet wird. Eine geringere Flexibilität bzw. eine höhere Steifigkeit dämpft beispielsweise die akustischen Eigenschaften. Wird dagegen die Wandlereinheit beispielsweise als Drucksensor verwendet, kann durch die Wahl der Flexibilität des Membranelements ein Druckbereich festgelegt werden, bei dem die Wandlereinheit den Druck messen kann. Es ist klar, dass bei hohen Drücken, das Membranelement eine geringere Flexibilität aufweisen muss, um die eigene Auslenkung begrenzen zu können. Die Flexibilität kann dabei mittels dem Membranmaterial bzw. der Zusammensetzung des Membranmaterials gewählt werden. Beispielsweise wird für eine geringere Flexibilität ein Membranmaterial gewählt, welches nach dem Aushärten ein höheres E-Modul aufweist. Es kann zusätzlich oder alternativ auch eine Dicke des zumindest einen Membranelements variiert werden, um dessen Flexibilität bzw. Steifigkeit anzupassen.

Von Vorteil ist es, wenn das fließfähige und aushärtbare Membranmaterial derart an das Verstärkungselement angegossen wird, dass das zumindest eine flexible Membranelement und/oder die Membraneinheit zum Wandlerelement separat ausgebildet wird. Zusätzlich oder alternativ kann auch das Verstärkungselement derart angeordnet werden, dass das zumindest eine flexible Membranelement und/oder die Membraneinheit zum Wandlerelement separat ausgebildet wird. Durch die Separierung des zumindest einen flexiblen Membranelements und/oder der Membraneinheit vom Wandlerelement kann die Wandlereinheit modular aufgebaut werden. Insbesondere ist nach dem Aushärten des Membranmaterials das Wandlerelement und die Membraneinheit voneinander getrennt bzw. lediglich über eine Kopplung miteinander verbunden.

Vorteilhaft ist es, wenn das zumindest eine Wandlerelement mit dem zumindest einen Verstärkungselement gekoppelt wird und anschließend das Membranelement angegossen wird. Dadurch wird zuerst eine feste Verbindung zwischen dem Verstärkungselement und dem Wandlerelement ausgebildet und anschließend das Membranelement an die Einheit aus Wandlerelement und Verstärkungselement angeordnet.

Von Vorteil ist es, wenn das zumindest eine Wandlerelement in einem Aufnahmeraum einer Dammanordnung angeordnet wird. Dabei kann die Dammanordnung zuerst auf dem Trägerelement angeordnet werden und daraufhin das Wandlerelement. Alternativ ist es auch möglich, dass zuerst das Wandlerelement und dann die Dammanordnung auf dem Trägerelement angeordnet wird. Die Dammanordnung weist eine Form eines Rahmens auf dem Trägerelement mit dem Aufnahmeraum auf. In die Dammanordnung bzw. den dadurch ausgebildeten Aufnahmeraum kann das fließfähige Membranmaterial eingefüllt werden. Mit Hilfe der Dammanordnung kann das fließfähige Membranmaterial zurückgehalten werden bzw. an dem Bereich zurückgehalten werden, an dem das zumindest eine Membranelement ausgebildet werden soll.

Ist das Wandlerelement im Aufnahmeraum angeordnet, umrandet die Dammanordnung das Wandlerelement vollständig. Ferner umrandet die Dammanordnung auch das Verstärkungselement vollständig, wenn es mit dem Wandlerelement gekoppelt ist.

Vorteilhaft ist es, wenn das zumindest eine Membranelement in einer quer zur Hubachse orientierten Querrichtung an das Verstärkungselement angegossen wird. Das Verstärkungselement weist eine Umfangsseite auf, welche sich quer zur Hubachse um das Verstärkungselement erstreckt. Das zumindest eine Membranelement wird somit an die Umfangsseite des Verstärkungselement angegossen. Die Umfangsseite ist ferner der Dammanordnung zugewandt. Wenn das Membranelement in der Querrichtung an das Verstärkungselement angegossen und somit ausgebildet wird, vergrößert es eine Fläche der Membraneinheit, so dass beispielsweise eine Akustikleistung der Wandlereinheit vergrößert wird.

Zusätzlich oder alternativ ist es von Vorteil, wenn das zumindest eine Membranelement an die Dammanordnung angegossen wird. Da die Dammanordnung fest mit dem Trägerelement verbunden ist, weist die Membraneinheit mittels der Kopplung des Membranelements an der Dammanordnung eine Verankerung mit dem Trägersubstrat auf. Die Membraneinheit kann daraufhin gemäß einem Audiosignal schwingen bzw. ausgelenkt werden, um einen Schall zu erzeugen, wenn die Wandlereinheit als Lautsprecher verwendet wird. Die Membraneinheit ist somit über das Membranelement an der Dammanordnung eingespannt. Die Membraneinheit ist an der Dammanordnung befestigt.

Zusätzlich oder alternativ ist es vorteilhaft, wenn das zumindest eine Membranelement zwischen Verstärkungselement und Dammanordnung angeordnet wird. Da sich die Dammanordnung vollständig um das Verstärkungselement erstrecken kann, kann das zumindest eine Membranelement vollständig im Bereich zwischen der Dammanordnung und dem Verstärkungselement angeordnet sein. Die Membraneinheit kann mit der Dammanordnung auch eine geschlossene Fläche bilden, wenn das zumindest eine Membranelement zwischen dem Verstärkungselement und der Dammanordnung angeordnet wird. Infolgedessen kann die Membraneinheit ein umgebendes Medium, wie beispielsweise Luft zur Erzeugung und/oder Erfassung von Schall, mit Druck und/oder Schwingungen beaufschlagen.

Von Vorteil ist es, wenn das Membranmaterial in Richtung der Hubachse zumindest teilweise an einer ersten und/oder zweiten Stirnseite des Verstärkungselements angegossen wird, so dass das zumindest teilweise an der ersten und/oder der zweiten Stirnseite des Verstärkungselements ausgebildet wird. Das Membranmaterial kann auch in einem Randbereich der ersten und/oder zweiten Stirnseite des Verstärkungselements angegossen werden. Das Verstärkungselement kann beispielsweise eine Dicke in Richtung der Hubachse von lediglich einigen µm, beispielsweise 1 - 5 µm aufweisen. Die Umfangsseite ist somit entsprechend gering, so dass zur Verbesserung der Verbindung zwischen dem Verstärkungselement und dem zumindest einen Membranelement, die erste und/oder zweite Stirnseite, beispielsweise in deren Randbereichen, mit dem Membranmaterial umgossen wird. Das Verstärkungselement wird infolgedessen von dem zumindest einen Membranelement eingefasst. Das Membranelement umgreift dadurch, das Verstärkungselement zumindest teilweise. Eine Verbindung zwischen dem zumindest einen Membranelement und dem Verstärkungselement wird dadurch verbessert.

Abschnitte des Verstärkungselements, insbesondere an der ersten und/oder der zweiten Stirnseite, können ferner, beispielsweise durch chemische Prozesse, angeraut werden, so dass eine formschlüssige Verbindung zwischen dem Verstärkungselement und dem Membranelement ausgebildet werden kann.

Vorteilhaft ist es, wenn die Dammanordnung, das Wandlerelement und/oder das Verstärkungselement derart zueinander angeordnet werden, dass das Verstärkungselement von der Dammanordnung beabstandet ist. Infolgedessen kann das Verstärkungselement kontaktlos und/oder frei gegenüber der Dammanordnung ausgelenkt werden.

Ferner wird das zumindest eine Membranelement derart angeordnet, dass es von dem Wandlerelement beabstandet ist. Dazu wird das Membranmaterial derart an das Verstärkungselement angegossen, dass das daraus ausgebildete Membranelement von dem Wandlerelement beabstandet ist. Dadurch wird das flexible Membranelement nicht beim Auslenken von dem Wandlerelement behindert.

Vorteilhaft ist es, wenn das Verstärkungselement und/oder das Wandlerelement zur Dammanordnung koaxial angeordnet werden. Zusätzlich oder alternativ können auch das Verstärkungselement und das Wandlerelement zueinander koaxial angeordnet werden. Dadurch können die Schwingungseigenschaften der Membraneinheit verbessert werden, wenn die Wandlereinheit beispielsweise als Schallwandler verwendet wird. Die Membraneinheit kann dadurch ausgelenkt werden, ohne dass diese beispielsweise kippt bzw. dass sich beim Auslenken die Orientierung der Membraneinheit ändert.

Von Vorteil ist es, wenn die Dammanordnung auf dem Trägerelement angeklebt wird. Zusätzlich oder alternativ kann die Dammanordnung auch einteilig während dem Ausbilden des Trägerelements mit diesem ausgebildet werden. Ferner kann beispielsweise eine Schablone auf das Trägerelement gelegt werden, welche mit einem Dammmaterial, aus welchem die Dammanordnung ausgebildet wird, gefüllt wird. Das Dammmaterial kann beispielsweise ebenfalls ein Polymer sein.

Des Weiteren wird zwischen dem Wandlerelement und dem Verstärkungselement ein Koppelelement angeordnet. Mit Hilfe des Koppelelements kann das Wandlerelement mit dem Verstärkungselement gekoppelt werden. Das Koppelelement wird zwischen Wandlerelement und dem Verstärkungselement angeordnet, um das Wandlerelement von dem Verstärkungselement zu beabstanden. Dadurch kann erreicht werden, dass auch bei einer maximalen Auslenkung der Membraneinheit und somit des Verstärkungselements, das Verstärkungselement bzw. die Membraneinheit noch von dem Wandlerelement beabstandet ist. Es wird dadurch verhindert, dass beim Auslenken der Membraneinheit, diese an dem Wandlerelement anstößt. Das Koppelelement kann ferner einteilig mit dem Wandlerelement oder dem Verstärkungselement ausgebildet werden. Alternativ kann das Koppelelement auch zuerst mit dem Wandlerelement oder dem Verstärkungselement verbunden werden, und daraufhin mit dem entsprechenden Gegenstück, also dem Verstärkungselement oder dem Wandlerelement.

Von Vorteil ist es, wenn das Membranmaterial zur Ausbildung des zumindest einen Membranelements in ein Membranvolumen eingegossen wird, das sich in einer quer zur Hubachse orientierten Querrichtung an das Verstärkungselement angrenzt. Das Membranvolumen ist somit das Volumen, an dem das Membranelement ausgebildet werden soll.

Zusätzlich oder alternativ kann das Membranvolumen in Querrichtung zwischen Verstärkungselement und Dammanordnung angeordnet sein.

Vorteilhaft ist es, wenn zumindest ein Füllvolumen im Aufnahmeraum mit einem fließfähigen und aushärtbaren Füllmaterial vergossen wird. Nach dem Aushärten bildet sich somit im Aufnahmeraum ein Füllelement aus. Das Füllmaterial kann dabei an das Verstärkungselement, an das Wandlerelement und/oder an die Dammanordnung angegossen werden. Zusätzlich oder alternativ kann das Füllelement auch an das zumindest eine, insbesondere ausgehärtete, Membranelement angegossen werden. Das Füllelement ist dabei ebenfalls flexibel. Vorzugsweise kann das Füllelement eine höhere Flexibilität als das Membranelement aufweisen. Mit Hilfe des Füllelements können beispielsweise die akustischen Eigenschaften der Wandlereinheit verändert und/oder bestimmt werden, wenn die Wandlereinheit als Schallwandler verwendet wird. Das zumindest eine Füllvolumen grenzt dabei an dem Membranelement an und/oder ist von diesem beabstandet.

Von Vorteil ist es, wenn das Füllmaterial in den Aufnahmeraum gegossen wird, bevor und/oder nachdem das Membranmaterial an das Verstärkungselement angegossen wird/ist. Es kann somit beispielsweise zuerst ein Füllmaterial in den Aufnahmeraum gegossen werden, dann das Membranmaterial an das Verstärkungselement und daraufhin wieder ein Füllmaterial in den Aufnahmeraum gegossen werden. Infolgedessen kann die Wandlereinheit Schritt für Schritt hergestellt werden.

Vorteilhaft ist es, wenn in dem Trägerelement zumindest eine Eingießöffnung ausgebildet wird, so dass das Membran- und/oder Füllmaterial durch die Eingießöffnung eingegossen werden kann. Dadurch kann das Membran- und/oder Füllmaterial in den Aufnahmeraum eingegossen werden.

Von Vorteil ist es, wenn an einer Oberseite der Wandlereinheit die Membraneinheit und an einer Unterseite die Eingießöffnung angeordnet ist, wobei aus Richtung der Unterseite das Membran- und/oder das Füllmaterial eingegossen wird.

Vorteilhaft ist es, wenn das Verstärkungselement und/oder die Dammanordnung auf ein Hilfselement aufgesetzt werden und das Membranmaterial und/oder das Füllmaterial aus Richtung des Trägerelements eingegossen wird. Das Hilfselement kann beispielsweise eine Platte sein, so dass die Platte den Aufnahmeraum der Dammanordnung verschließt. Wenn das Membranmaterial eingefüllt wird, sammelt es sich über dem Hilfselement im Aufnahmeraum und bildet nach dem Aushärten das zumindest eine Membranelement.

Von Vorteil ist es, wenn während und/oder nach dem Eingießen des Membran- und/oder des Füllmaterials die Wandlereinheit geschwenkt und/oder vibriert wird. Dadurch verteilt sich das Membran- und/oder des Füllmaterial.

Zusätzlich oder alternativ ist es vorteilhaft, wenn das Membran- und/oder das Füllmaterial unter Druck vergossen wird. Dadurch kann die Herstellung beschleunigt werden.

Vorteilhaft ist es, wenn das Membranmaterial und das Füllmaterial nacheinander, insbesondere unter Wärmeeintrag, ausgehärtet werden.

Vorgeschlagen wird außerdem eine Wandlereinheit, insbesondere einer MEMS-Wandlereinheit, zum Wandeln von Auslenkungen in elektrische Signale und/oder von elektrischen Signalen in Auslenkungen, vorzugsweise zum Erzeugen und/oder Erfassen von Schallwellen im hörbaren Wellenlängenbereich und/oder im Ultraschallbereich.

Die Wandlereinheit umfasst ein Trägerelement und zumindest ein auf dem Trägerelement angeordnetes Wandlerelement. Mit Hilfe des Wandlerelements können die Auslenkungen in elektrische Signale und/oder elektrische Signale in Auslenkungen umgewandelt werden. Das Wandlerelement kann beispielsweise einen Piezoaktor umfassen, der elektrische Signale in Auslenkungen und Auslenkungen in elektrische Signale umwandeln kann.

Ferner umfasst die Wandlereinheit eine mit dem Wandlerelement gekoppelte Membraneinheit. Mittels der Membraneinheit können die Auslenkungen auf ein umgebendes Medium, wie beispielsweise Luft, übertragen werden, wobei infolgedessen Schall erzeugt wird. Zusätzlich oder alternativ können auch Schwingungen und/oder ein Druck des Mediums zu den Auslenkungen der Membraneinheit führen, welche auf das Wandlerelement übertragen werden, wobei das Wandlerelement daraus das elektrische Signal erzeugt.

Erfindungsgemäß umfasst die Membraneinheit ein Verstärkungselement, welches mit dem Wandlerelement gekoppelt ist und an welches zumindest ein flexibles Membranelement zumindest abschnittsweise angegossen ist, so dass das Verstärkungselement zusammen mit dem Membranelement zumindest teilweise die Membraneinheit ausbilden.

Ferner kann die Wandlereinheit gemäß einem oder mehreren Verfahrensmerkmalen der vorangegangenen und/oder nachfolgenden Beschreibung ausgebildet sein. Zusätzlich oder alternativ kann auch ein Verfahrensschritt für das vorangegangene Verfahren durchgeführt werden, um eine Wandlereinheit auszubilden, welche zumindest ein Merkmal der nachfolgenden Beschreibung aufweist.

Von Vorteil ist es, wenn das Wandlerelement und die Membraneinheit separat zueinander angeordnet sind. Das heißt, das Wandlerelement und die Membraneinheit sind zueinander separate Einheiten, Elemente oder Bauteile. Dadurch kann die Wandlereinheit modular aufgebaut werden.

Zusätzlich oder alternativ ist es von Vorteil, wenn das Wandlerelement und die Membraneinheit voneinander beabstandet angeordnet sind. Dabei sind auch das Wandlerelement und das zumindest eine flexible Membranelement voneinander beabstandet. Zusätzlich kann auch das Wandlerelement und das Verstärkungselement voneinander beabstandet sein.

Zusätzlich oder alternativ ist es von Vorteil, wenn das Wandlerelement und die Membraneinheit mittels einem Koppelelement miteinander gekoppelt sind. Ferner sind das Wandlerelement mittels dem Koppelelement mit dem Verstärkungselement gekoppelt. Zusätzlich oder alternativ können auch das Wandlerelement und die Membraneinheit, insbesondere das Verstärkungselement, lediglich und/oder ausschließlich mittels dem Koppelelement miteinander gekoppelt sein. Infolgedessen erfolgt die Übertragung der Auslenkungen zwischen dem Wandlerelement und der Membraneinheit lediglich über das Koppelelement.

Vorteilhaft ist es, wenn das Wandlerelement mittels zumindest einem Fußelement, insbesondere mittels zumindest zwei Fußelementen, auf dem Trägerelement angeordnet ist. Dadurch ist das Wandlerelement von dem Trägerelement beabstandet.

Vorteilhaft ist es, wenn ein Membran- und/oder Füllmaterial ein E-Modul von kleiner als 10MPa, insbesondere kleiner 1MPa, aufweist. Vorzugsweise ist das E-Modul des Membranmaterials größer als das des Füllmaterials.

Von Vorteil ist es auch, wenn das Membranmaterial und das Füllmaterial unterschiedlich sind. Alternativ können das Membranmaterial und das Füllmaterial gleich sein.

Weitere Vorteile der Erfindung sind in den nachfolgenden Ausführungsbeispielen beschrieben. Es zeigen:
- **Figur 1**: einen schematischen Querschnitt einer Wandlereinheit mit Wandlerelement und Membraneinheit,
- **Figur 2**: einen schematischen Querschnitt einer Wandlereinheit mit Wandlerelement und Membraneinheit auf einem Hilfselement,
- **Figur 3**: einen schematischen Querschnitt einer Wandlereinheit mit Wandlerelement und Membraneinheit und
- **Figur 4**: einen schematischen Querschnitt einer Wandlereinheit mit Wandlerelement und Membraneinheit.

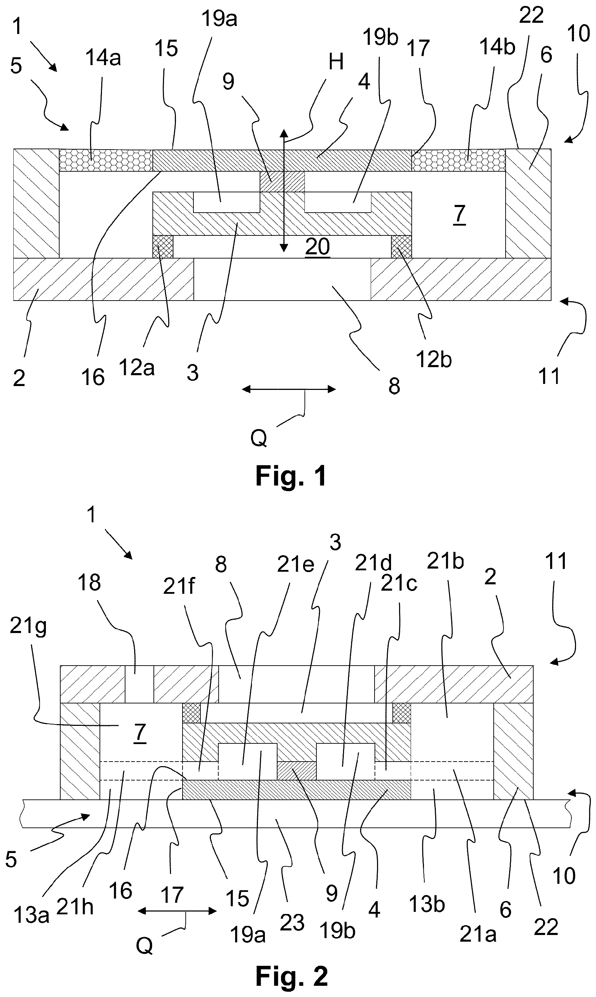

Figur 1 zeigt einen schematischen Querschnitt einer Wandlereinheit 1. Mittels der Wandlereinheit 1 können elektrische Signale in Auslenkungen gewandelt werden. Dies erfolgt beispielsweise dann, wenn die Wandlereinheit 1 als Lautsprecher oder als Aktor verwendet wird. Zusätzlich oder alternativ können mittels der Wandlereinheit 1 auch Auslenkungen in elektrische Signale gewandelt werden. Dies erfolgt beispielsweise dann, wenn die Wandlereinheit 1 als Mikrofon oder Sensor verwendet wird. Die Wandlereinheit 1 ist eine MEMS-Wandlereinheit. Mittels den Auslenkungen können beispielsweise ein Druck oder eine Kraft ausgebildet werden.

Die Wandlereinheit 1 umfasst ein Trägerelement 2, auf welchem zumindest ein Wandlerelement 3 angeordnet ist. Mit Hilfe des Wandlerelements 3 können die Auslenkungen in die elektrischen Signale und/oder die elektrischen Signale in Auslenkungen gewandelt werden. Das Wandlerelement 3 kann somit beispielsweise zur Erzeugung und/oder Erfassung von Schallwellen dienen. Des Weiteren kann das Wandlerelement 3 in Richtung einer Hubachse H ausgelenkt werden, um infolgedessen die Auslenkungen und/oder die elektrischen Signale zu erzeugen. Das Wandlerelement 3 kann beispielsweise ein Substrat und zumindest einen Piezoaktor umfassen. Mit Hilfe des Piezoaktors können die elektrischen Signale in Auslenkungen und/oder die Auslenkungen in die elektrischen Signale umgewandelt werden. Der Piezoaktor kann sich dabei entlang der Hubachse H auslenken oder ausgelenkt werden.

Außerdem umfasst die Wandlereinheit 1 eine Membraneinheit 5, welche mit dem zumindest einen Wandlerelement 3 gekoppelt ist. Mittels der Membraneinheit 5 können beispielsweise Schwingungen als Auslenkungen von dem Wandlerelement 3 auf die umgebende Luft übertragen werden, so dass Schall erzeugt wird und die Wandlereinheit 1 somit als Lautsprecher betrieben wird. Zusätzlich oder alternativ können mittels der Membraneinheit 5 auch Schallwellen in Schwingungen als Auslenkungen erfasst werden, welche vom Wandlerelement 3 in ein elektrisches Signal gewandelt werden. Die Wandlereinheit 1 kann somit als Mikrofon betrieben werden. Dabei kommt es natürlich nicht darauf an, ob Schall die Membraneinheit 5 auslenkt. Beispielsweise kann die Wandlereinheit 1 auch ein Druck- oder Kraftsensor sein, so dass ein anderes Medium als Luft die Membraneinheit 5 auslenkt, wobei diese Auslenkung vom Wandlerelement 3 in ein elektrisches Signal umgewandelt wird.

Das zumindest eine Wandlerelement 3 ist dabei entlang einer Hubachse H auslenkbar.

Das Wandlerelement 3 kann beispielsweise zumindest ein Piezoelement oder Piezoaktor umfassen, welches bei Auslenkung eine elektrische Spannung erzeugt und beim Anlegen einer elektrischen Spannung sich selbst auslenkt.

Die Wandlereinheit 1 kann aber auch ein sonstiger Sensor und/oder Aktor sein. Beispielsweise kann die Wandlereinheit 1 ein Druck- oder Kraftsensor sein, welcher anhand einer Auslenkung des Wandlerelements 3 einen Druck oder eine Kraft ermittelt. Als Aktor kann die Wandlereinheit 1 auch einen Druck oder eine Kraft ausbilden.

Des Weiteren weist die Wandlereinheit 1 des vorliegenden Ausführungsbeispiels eine Dammanordnung 6 auf, welche insbesondere zusammen mit dem Trägerelement 2 einen Aufnahmeraum 7 begrenzt. Hier ist das Wandlerelement 3 und das Verstärkungselement 4 im Aufnahmeraum 7 angeordnet.

Weiterhin ist im vorliegenden Ausführungsbeispiel zwischen dem Wandlerelement 3 und dem Verstärkungselement 4 ein Koppelelement 9 angeordnet. Mit Hilfe des Koppelelements 9 wird ferner die Membraneinheit 5 und/oder das Verstärkungselement 4 von dem Wandlerelement 3 beabstandet, so dass verhindert werden kann, dass beim Auslenken der Membraneinheit 5 und/oder des Verstärkungselements 4 dieses an der Wandlereinheit 3 anstößt. Dabei kann das Koppelelement 9 auch einteilig mit dem Wandlerelement 3, der Membraneinheit 5 und/oder dem Verstärkungselement 4 ausgebildet sein.

Des Weiteren kann, wie hier gezeigt ist, die Membraneinheit 5 von dem Wandlerelement 3 separiert bzw. separat angeordnet sein. Die Membraneinheit 5 und das Wandlerelement 3 sind voneinander getrennt angeordnet und/oder ausgebildet. Die Membraneinheit 5 und das Wandlerelement 3 sind lediglich mittels dem Koppelelement 9 miteinander gekoppelt. Durch die separate Anordnung und/oder Ausbildung der Membraneinheit 5 und des Wandlerelements 3 ist die Wandlereinheit 1 modular aufgebaut. Die Wandlereinheit 1 kann dadurch beispielsweise schrittweise aufgebaut werden. Für den Fall, dass ein Bauelement der Wandlereinheit 1 beschädigt oder nicht korrekt angeordnet und/oder ausgebildet ist, kann dieses Bauelement wieder entfernt oder neu angeordnet oder ausgebildet werden.

Die Wandlereinheit 1 weist außerdem eine Oberseite 10 und eine dazu, insbesondere in Richtung der Hubachse H, gegenüberliegenden Unterseite 11 auf. Die Membraneinheit 5 ist dabei an der Oberseite 10 angeordnet. Im Bereich der Unterseite 11 ist das Trägerelement 2 angeordnet.

Das Verstärkungselement 4 weist ebenfalls eine erste Stirnseite 15 und eine zweite Stirnseite 16 auf, wobei beide Stirnseiten 15, 16 in Richtung der Hubachse H voneinander beabstandet sind. Dabei ist die erste Stirnseite 15 der Oberseite 10 zugewandt. Ferner bildet die erste Stirnseite 15 einen Teil der Oberseite 10. Die erste Stirnseite 15 ist ferner vom Wandlerelement 3 abgewandt. Die zweite Stirnseite 16 ist dem Wandlerelement 3 zugewandt. Ferner ist die erste Stirnseite 15 bzw. das Verstärkungselement 4 derart angeordnet, dass die erste Stirnseite 15 mit der Dammanordnung 6 bündig ist. Die erste Stirnseite 15 ist mit einer Dammoberseite 22 bündig.

Die Membraneinheit 5 weist ferner zumindest ein flexibles Membranelement 14a, b auf, welches beim Verfahren zur Herstellung der Wandlereinheit 1 dadurch ausgebildet wird, dass fließfähiges und aushärtbares Membranmaterial an das Verstärkungselement 4 angegossen wird. Die Membraneinheit 5 umfasst somit das Verstärkungselement 4 und das zumindest eine Membranelement 14a, b.

Durch das Angießen des Membranmaterials an das Verstärkungselement 4 zur Ausbildung des zumindest einen Membranelements 14a, b kann auf annähernd jede Form der Membraneinheit 5 eingegangen werden, ohne das Membranelement 14a, b vorher zu fertigen. Außerdem werden durch das Angießen des Membranmaterials Toleranzen während der Herstellung ausgeglichen. Ferner können die akustischen Eigenschaften der Wandlereinheit 1, wenn diese als Schallwandler verwendet wird, nahezu beliebig angepasst werden, wenn beispielsweise weniger oder mehr Membranmaterial an das Verstärkungselement 4 angegossen wird, so dass ein dünneres oder dickeres Membranelement 14a, b ausgebildet wird. Eine derartige Entscheidung kann noch während des Herstellungsprozesses getroffen werden. Mittels des Angießens des zumindest einen Membranelements 14a, b wird das Herstellungsverfahren flexibler.

Das Verstärkungselement 4 weist ferner eine Umfangsseite 17 auf, welche eine Umfangsfläche bildet. Die Umfangsseite 17 erstreckt sich dabei vollständig um das Verstärkungselement 4. Die Umfangsseite 17 ist dabei der Dammanordnung 6 zugewandt. Hier ist das zumindest eine Membranelement 14a, b zumindest abschnittsweise an der Umfangsseite 17 angegossen. Ferner erstreckt sich das zumindest eine Membranelement 14a, b zwischen dem Verstärkungselement 4, insbesondere der Umfangsseite 17, und der Dammanordnung 6.

Gemäß dem vorliegenden Ausführungsbeispiel sind zwei Membranelemente 14a, b gezeigt. Wenn sich das Membranelement 14a, b vollständig um das Verstärkungselement 4 erstreckt, umfasst die Membraneinheit 5 lediglich ein Membranelement 14. Die beiden hier gezeigten Membranelemente 14a, b können somit zusammenhängen. Das Membranelement 14 kann sich vollständig um das Verstärkungselement 4 erstrecken, wenn das Verstärkungselement 4 vollständig von der Dammanordnung 6 beabstandet ist, d.h. keinen Kontakt zur Dammanordnung 6 aufweist.

Das zumindest eine Membranelement 14a, b kann, wie hier gezeigt ist, bündig mit der ersten und/oder zweiten Stirnseite 15, 16 des Verstärkungselements 4 sein.

Gemäß dem vorliegenden Ausführungsbeispiel ist das Verstärkungselement 4 mittig zwischen der Dammanordnung 6 angeordnet. Das zumindest eine Membranelement 14a, b ist somit ebenfalls symmetrisch.

Gemäß dem vorliegenden Ausführungsbeispiel umfasst die Wandlereinheit 1 zumindest ein Fußelement 12a, b, mit welchem das Wandlerelement 3 auf dem Trägerelement 2 angeordnet ist. Mit Hilfe des zumindest einen Fußelements 12a, b kann die Wandlereinheit 3 von dem Trägerelement 2 beabstandet werden, so dass die Wandlereinheit 3 beim Auslenken nicht an dem Trägerelement 2 anstößt. Hier sind zwei Fußelemente 12a, b gezeigt.

Das Trägerelement 2 weist des Weiteren gemäß dem vorliegenden Ausführungsbeispiel eine Durchgangsöffnung 8 auf. Mit Hilfe der Durchgangsöffnung 8 kann eine Akustik der Wandlereinheit 1 angepasst bzw. verbessert werden, wenn die Wandlereinheit 1 ein Schallwandler ist. Die hier gezeigte Durchgangsöffnung 8 ist an der Unterseite 11 angeordnet. Die Durchgangsöffnung 8 des vorliegenden Ausführungsbeispiels ist ferner zwischen den beiden Fußelementen 12a, b angeordnet. Die Durchgangsöffnung 8 kann ebenfalls beim Herstellungsverfahren ausgebildet werden.

Das zumindest eine Wandlerelement 3 weist ferner zumindest eine Aussparung 19a, b auf. Hier sind zwei Aussparungen 19a, b gezeigt, wobei es sich auch lediglich um eine einzige Aussparung 19 handeln kann, welche sich, wie hier gezeigt ist, um das Koppelelement 9 erstreckt. Mit Hilfe der Aussparung 19a, b kann sich das Wandlerelement 3 besser auslenken oder ausgelenkt werden. Die Bereiche bei der zumindest einen Aussparung 19a, b können einen Sollbiegebereich oder einen Sollauslenkbereich bilden.

Die Wandlereinheit 1 weist außerdem ein Hintervolumen 20 auf, welches auf der zur Membraneinheit 5 abgewandten Seite des Wandlerelements 3 angeordnet ist. Das Hintervolumen 20 kann auch teilweise die Durchgangsöffnung 8 umfassen. Mittels des Hintervolumens 20 kann ebenfalls die Akustik angepasst werden. Das Hintervolumen 20 kann dabei ebenfalls beim Herstellungsverfahren ausgebildet werden.

Figur 2 zeigt die Wandlereinheit 1 mit Abschnitten zum Eingießen zumindest des Membranmaterials.

Ferner werden der Einfachheit halber Merkmale und deren Wirkung, die bereits in den vorangegangenen Figuren beschrieben sind, nicht nochmals erklärt. Ferner weisen im Vergleich zu den vorangegangenen und/oder nachfolgenden Figuren gleiche Merkmale oder zumindest ähnlich wirkende Merkmale gleiche Bezugszeichen auf. So können beispielsweise Merkmale der Übersichtlichkeit halber auch erst in den folgenden Figuren beschrieben sein.

Die Wandlereinheit 1 ist hier in einer anderen bzw. entgegengesetzten Orientierung gezeigt. In Figur 1 war die Oberseite 10 oben, wohingegen in Figur 2 die Unterseite 11 oben ist.

Gemäß dem vorliegenden Ausführungsbeispiel weist das Trägerelement 2 eine Eingießöffnung 18 auf. Die Eingießöffnung 18 ist hier an der Unterseite 11 angeordnet. Beim Herstellungsverfahren der Wandlereinheit 1 kann diese derart gedreht und/oder orientiert werden, dass die Unterseite 11 oben ist, so dass das fließfähige Membranmaterial durch die Eingießöffnung 18 in den Aufnahmeraum 7 eingegossen werden kann.

Beim Herstellungsverfahren kann die Wandlereinheit 1 auf ein Hilfselement 23 aufgesetzt werden. Das Hilfselement 23 ist hier eine Platte oder zumindest plattenförmig ausgebildet. Mittels des Hilfselements 23 kann der Aufnahmeraum 7 an der Oberseite 10 begrenzt bzw. abgedichtet werden, so dass das Membranmaterial in den Aufnahmeraum 7 eingefüllt und dort zurückgehalten wird. Das Hilfselement 23 ist hier nicht schraffiert gezeigt.

Gemäß dem vorliegenden Ausführungsbeispiel weist die Wandlereinheit 1, insbesondere der Aufnahmeraum 7, zumindest ein Membranvolumen 13a, b auf, welches mit dem Membranmaterial gefüllt wird und in welchem nach dem Aushärten das zumindest eine Membranelement 14a, b (vgl. Figur 1) ausgebildet wird.

Das Membranvolumen 13a, b wird hier von der Dammanordnung 6, dem Verstärkungselement 4 und dem Hilfselement 23 begrenzt. Die Dammanordnung 6 mit der Dammoberseite 22 und das Verstärkungselement 4 mit der ersten Stirnseite 15 weisen hier einen Kontakt zum Hilfselement 23 auf. Die Dammanordnung 6 mit der Dammoberseite 22 und das Verstärkungselement 4 mit der ersten Stirnseite 15 liegen ferner plan auf dem Hilfselement 23. Eine Kontaktfläche zwischen dem Hilfselement 23 und dem Verstärkungselement 4 und/oder der Dammanordnung 6 ist zumindest dicht für das Membranmaterial.

Das Membranmaterial kann somit durch die Eingießöffnung 18 aus Richtung der Unterseite 11 in den Aufnahmeraum 7 eingefüllt werden. Das Membranvolumen 13a, b ist hier am niedrigsten Punkt angeordnet, so dass das Membranmaterial selbstständig, also schwerkraftbedingt, in das Membranvolumen fließt. Nach dem Aushärten ist das zumindest eine Membranelement 14a, b ausgebildet.

Der Aufnahmeraum 7 kann außerdem noch weiter unterteilt werden. Zusätzlich zum Membranvolumen kann die Wandlereinheit 1 bzw. der Aufnahmeraum 7 zumindest ein Füllvolumen 21 aufweisen, in welches ein Füllmaterial eingefüllt werden kann.

Dabei kann das Membranmaterial und das Füllmaterial in beliebiger Reihenfolge eingefüllt werden. Beispielsweise kann, wie in dem in Figur 2 gezeigten Ausführungsbeispiel gezeigt ist, zuerst das Membranmaterial eingefüllt werden, da das Membranvolumen 13a, b am tiefsten Bereich (in Bezug auf die durch die Schwerkraft bedingte Fließrichtung) angeordnet ist. Ist das Membranmaterial eingefüllt, kann es beispielsweise unter Wärmezufuhr ausgehärtet werden, so dass das zumindest eine Membranelement 14a, b ausgebildet wird.

Anschließend kann das Füllmaterial in das Füllvolumen 21, beispielsweise ebenfalls durch die Eingießöffnung 18, eingefüllt werden.

Gemäß dem vorliegenden Ausführungsbeispiel ist der Aufnahmeraum 7 neben dem Membranvolumen 13a, b in mehrere Füllvolumen 21a - g unterteilt.

Ein erstes Füllvolumen 21a ist hier zwischen dem zweiten Membranvolumen 13b und dem Trägerelement 2 angeordnet und grenzt an das zweite Membranvolumen 13b an. Ein zweites Füllvolumen 21b ist zwischen dem ersten Füllvolumen 21a und dem Trägerelement 2 angeordnet und grenzt an beide an.

Ein drittes Füllvolumen 21c ist zwischen Verstärkungselement 4 und dem Wandlerelement 3 angeordnet. Ein viertes Füllvolumen 21d ist ebenfalls zwischen Verstärkungselement 4 und dem Wandlerelement 3 angeordnet und überschneidet sich zumindest teilweise mit der Aussparung 19b aus. Ein fünftes Füllvolumen 21e ist ebenfalls zwischen Verstärkungselement 4 und dem Wandlerelement 3 angeordnet und überschneidet sich zumindest teilweise mit der Aussparung 19a. Ein sechstes Füllvolumen 21f ist zwischen Verstärkungselement 4 und dem Wandlerelement 3 angeordnet.

Ein siebtes Füllvolumen 21g ist zwischen Trägerelement 2 und einem achten Füllvolumen 21h angeordnet, wobei das achte Füllvolumen 21h an das Membranvolumen 13a angrenzt.

Das Füllmaterial für die verschiedenen Füllvolumen 21 ist dabei, wie das Membranmaterial, ebenfalls fließfähig und, beispielsweise unter Wärmezufuhr, aushärtbar.

Nach dem Verfüllen des Füllmaterials wird dies ebenfalls ausgehärtet, wobei dies aus sukzessive erfolgen kann.

Mit den verschiedenen mit Füllmaterial gefüllten Füllvolumen 21a - g kann beispielsweise die akustische Eigenschaft der Wandlereinheit 1 angepasst werden, wenn dieser als Schallwandler betrieben wird. Das Füllmaterial weist dazu vorteilhafterweise, wenn es ausgehärtet ist, ein E-Modul von kleiner 10 MPa oder bevorzugt kleiner als 1 MPa auf.

Mittels der Anpassung der akustischen Eigenschaften der Wandlereinheit 1 durch das ausgehärtete Füllmaterial kann auf andere Elemente zur Anpassung der akustischen Eigenschaften verzichtet werden. Beispielsweise können Gitter in den Aufnahmeraum 7 eingesetzt werden, um die akustischen Eigenschaften anzupassen, welche jedoch in komplizierten Verfahren gefertigt werden müssen. Weisen derartige Gitter fehlerhafte Abmessungen auf, können diese nicht eingesetzt werden. Das Füllmaterial kann dagegen in einem einfachen Schritt eingefüllt werden und passt sich selbstständig den Aufnahmeraum 7 bzw. dem entsprechenden Füllvolumen 21 an.

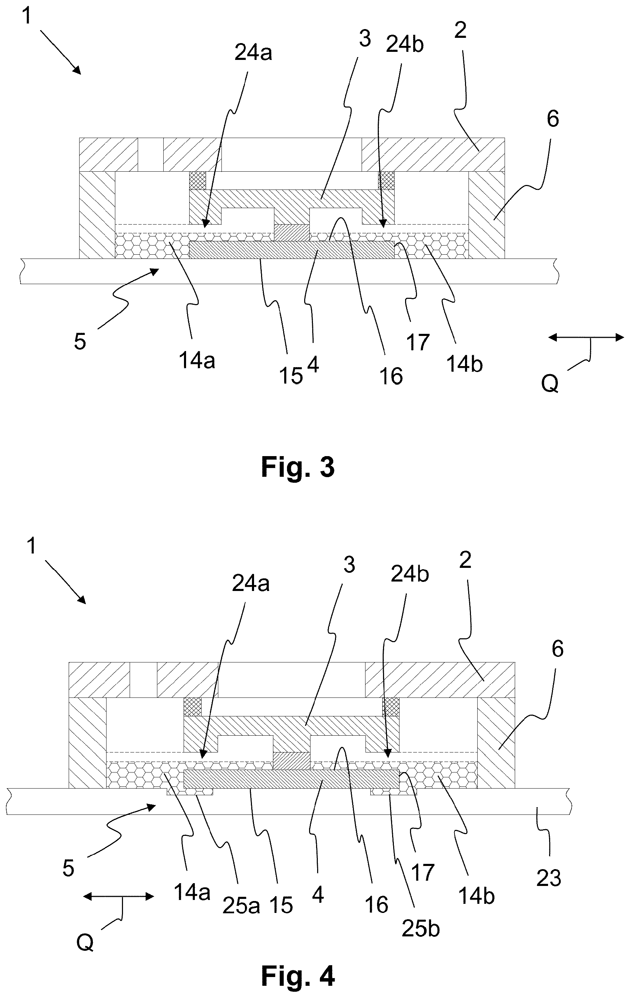

Figur 3 zeigt die Wandlereinheit 1 mit einer Membraneinheit 5.

Ferner werden der Einfachheit halber Merkmale und deren Wirkung, die bereits in den vorangegangenen Figuren beschrieben sind, nicht nochmals erklärt. Ferner weisen im Vergleich zu den vorangegangenen und/oder nachfolgenden Figuren gleiche Merkmale oder zumindest ähnlich wirkende Merkmale gleiche Bezugszeichen auf. So können beispielsweise Merkmale der Übersichtlichkeit halber auch erst in den folgenden Figuren beschrieben sein.

Gemäß dem vorliegenden Ausführungsbeispiel erstreckt sich das zumindest eine Membranelement 14a, b zumindest teilweise über die zweite Stirnseite 16. Dadurch kann eine Verbindung zwischen dem Verstärkungselement 4 und dem zumindest einen Membranelement 14a, b verstärkt werden. Hier bedeckt das zumindest eine Membranelement 14a, b die zweite Stirnseite 16 vollständig.

Zusätzlich oder alternativ kann sich das zumindest eine Membranelement 14a, b auch zumindest teilweise über die erste Stirnseite 15 erstrecken. Wenn sich das Membranelement 14a, b über beide Stirnseiten 15, 16 zumindest teilweise erstreckt, umgreift das Membranelement 14a, b das Verstärkungselement 4, so dass die Verbindung zwischen Verstärkungselement 4 und dem zumindest einen Membranelement 14a, b verstärkt ist.

Beim Herstellungsverfahren wird beispielsweise so viel Membranmaterial in den Aufnahmeraum 7 gefüllt, bis es die zweite Stirnseite 16 zumindest teilweise bedeckt, so dass es ausgehärtet werden kann.

Das Verstärkungselement 4 weist ferner zumindest einen Randbereich 24a, b auf, welcher der Dammanordnung 6 zugewandt ist. Das Verstärkungselement 4 kann auch nur einen Randbereich 24 aufweisen, welcher sich um das Verstärkungselement 4 erstreckt. Das zumindest eine Membranelement 14a, b kann auch zumindest im Randbereich 24a, b angeordnet sein.

Figur 4 zeigt die Wandlereinheit 1 mit einer Membraneinheit 5.

Ferner werden der Einfachheit halber Merkmale und deren Wirkung, die bereits in den vorangegangenen Figuren beschrieben sind, nicht nochmals erklärt. Ferner weisen im Vergleich zu den vorangegangenen und/oder nachfolgenden Figuren gleiche Merkmale oder zumindest ähnlich wirkende Merkmale gleiche Bezugszeichen auf. So können beispielsweise Merkmale der Übersichtlichkeit halber auch erst in den folgenden Figuren beschrieben sein.

Gemäß dem vorliegenden Ausführungsbeispiel ist das zumindest eine Membranelement 14a, b auch zumindest teilweise auf der ersten Stirnseite 15 angeordnet. Das Hilfselement 23 weist zumindest eine Vertiefung 25a, b auf, in welche das Membranmaterial einfließen kann, um nach dem Aushärten das Membranelement 14a, b zumindest teilweise auf der ersten Stirnseite 15 auszubilden. Mit Hilfe der Form der Vertiefungen 25a, b kann auch der Bereich des zumindest einen Membranelements 14a, b auf der ersten Stirnseite 15 festgelegt werden. Das Membranelement 14a, b kann, wie hier gezeigt ist, zumindest im Randbereich 24a, b des Verstärkungselements auf der ersten Stirnseite 15 angeordnet sein.

In einem alternativen Ausführungsbeispiel kann das zumindest eine Membranelement 14a, b auch nur auf der ersten Stirnseite 15 angeordnet sein. Das Membranmaterial wird dabei höchsten so lange in den Aufnahmeraum 7 eingefüllt, bis es mit der zweiten Stirnseite 16 bündig ist.

Die vorliegende Erfindung ist nicht auf die dargestellten und beschriebenen Ausführungsbeispiele beschränkt. Abwandlungen im Rahmen der Patentansprüche sind möglich.

### Bezugszeichenliste

- 1: Wandlereinheit
- 2: Trägerelement
- 3: Wandlerelement
- 4: Verstärkungselement
- 5: Membraneinheit
- 6: Dammanordnung
- 7: Aufnahmeraum
- 8: Durchgangsöffnung
- 9: Koppelelement
- 10: Oberseite
- 11: Unterseite
- 12: Fußelement
- 13: Membranvolumen
- 14: Membranelement
- 15: erste Stirnseite
- 16: zweite Stirnseite
- 17: Umfangsseite
- 18: Eingießöffnung
- 19: Aussparung
- 20: Hintervolumen
- 21: Füllvolumen
- 22: Dammoberseite
- 23: Hilfselement
- 24: Randbereich
- 25: Vertiefung

- H: Hubachse
- Z: Zentrum
- Q: Querrichtung
- A: Abstand

## Patentansprüche

1. Verfahren zum Herstellen einer MEMS-Wandlereinheit (1) zum Wandeln von elektrischen Signalen in Auslenkungen und/oder von Auslenkungen in elektrische Signale,
bei dem ein Wandlerelement (3) mit einer entlang einer Hubachse (H) auslenkbaren Membraneinheit (5), die zumindest teilweise durch ein Verstärkungselement (4) und ein flexibles Membranelement (14) ausgebildet ist, gekoppelt wird,
wobei auf einem Trägerelement (2) das zumindest eine Wandlerelement (3) angeordnet wird,
wobei zwischen dem Wandlerelement (3) und dem Verstärkungselement (4) ein Koppelelement (9) angeordnet ist, das das Wandlerelement (3) von dem Verstärkungselement (4) beabstandet,
wobei zur Ausbildung des zumindest einen flexiblen Membranelements (14) ein fließfähiges und aushärtbares Membranmaterial zumindest abschnittsweise an das mit dem Wandlerelement (3) gekoppelte Verstärkungselement (4) derart angegossen wird,
dass das Membranelement (14) zusammen mit dem Verstärkungselement (4) zumindest teilweise die Membraneinheit (5) ausbilden und dass das Membranelement (14) von dem Wandlerelement (3) beabstandet ist.

2. Verfahren nach dem vorherigen Anspruch, **dadurch gekennzeichnet, dass** das zumindest eine Wandlerelement (3) mit dem zumindest einen Verstärkungselement (4) gekoppelt wird und anschließend das Membranelement (14) angegossen wird.

3. Verfahren nach einem oder mehreren der vorherigen Ansprüche,
**dadurch gekennzeichnet, dass** das zumindest eine Wandlerelement (3) in einem Aufnahmeraum (7) einer Dammanordnung (6) angeordnet wird, so dass das Wandlerelement (3) und das Verstärkungselement (4) von der Dammanordnung (6) vollständig umrandet sind.

4. Verfahren nach dem vorherigen Anspruch 3, **dadurch gekennzeichnet, dass** das zumindest eine Membranelement (14) an die Dammanordnung (6) angegossen wird und/oder
dass das zumindest eine Membranelement (14) zwischen Verstärkungselement (4) und Dammanordnung (6) angeordnet wird.

5. Verfahren nach einem oder mehreren der vorherigen Ansprüche, **dadurch gekennzeichnet, dass** das Membranelement (14) an eine Umfangsseite (17) des Verstärkungselements (4) angegossen wird.

6. Verfahren nach einem oder mehreren der vorherigen Ansprüche 3 bis 5, **dadurch gekennzeichnet, dass** die Dammanordnung (6) und das Verstärkungselement (4) derart zueinander angeordnet werden, dass das Verstärkungselement (4) von der Dammanordnung (6) beabstandet ist.

7. Verfahren nach einem oder mehreren der vorherigen Ansprüche 3 bis 6, **dadurch gekennzeichnet, dass** das Membranmaterial zur Ausbildung des zumindest einen Membranelements (14) in ein Membranvolumen (13) eingegossen wird, das sich in einer quer zur Hubachse (H) orientierten Querrichtung an das Verstärkungselement (4) angrenzt.

8. Verfahren nach einem oder mehreren der vorherigen Ansprüche, **dadurch gekennzeichnet, dass** in dem Trägerelement (2) zumindest eine Eingießöffnung (18) ausgebildet wird, so dass das Membranmaterial durch die Eingießöffnung (18) eingegossen werden kann.

9. Verfahren nach einem oder mehreren der vorherigen Ansprüche, **dadurch gekennzeichnet, dass** das Verstärkungselement (4) auf ein Hilfselement (23) aufgesetzt wird und das Membranmaterial aus Richtung des Trägerelements (2) eingegossen wird.

10. MEMS-Wandlereinheit (1) zum Wandeln von Auslenkungen in elektrische Signale und/oder von elektrischen Signalen in Auslenkungen, die mittels eines Verfahrens gemäß einem oder mehreren der vorherigen Ansprüche ausgebildet ist,
mit einem Trägerelement (2),
zumindest einem auf dem Trägerelement (2) angeordneten Wandlerelement (3) und
mit einer mit dem Wandlerelement (3) gekoppelten Membraneinheit (5), die zumindest teilweise durch ein Verstärkungselement (4) und ein flexibles Membranelement (14) ausgebildet ist,
wobei zwischen dem Wandlerelement (3) und dem Verstärkungselement (4) ein Koppelelement (9) angeordnet ist, das das Wandlerelement (3) von dem Verstärkungselement (4) beabstandet,
wobei das Verstärkungselement (4) mit dem Wandlerelement (3) gekoppelt ist und
wobei an das Verstärkungselement (4) das flexible Membranelement (14) aus einem Membranmaterial zumindest abschnittsweise derart angegossen ist,
dass das Verstärkungselement (4) zusammen mit dem Membranelement (3) zumindest teilweise die Membraneinheit (5) ausbilden und dass das Membranelement (14) von dem Wandlerelement (3) beabstandet ist.

## Claims

1. A method for manufacturing a MEMS transducer unit (1) for transducing electrical signals into deflections and/or deflections into electrical signals,
in which a transducer element (3) is coupled to a diaphragm unit (5) which can be deflected along a reciprocation axis (H) and which is formed at least partially by a reinforcing element (4) and a flexible diaphragm element (14),
wherein the at least one transducer element (3) is arranged on a support element (2),
wherein a coupling element (9) is arranged between the transducer element (3) and the reinforcing element (4) and spaces the transducer element (3) from the reinforcing element (4),
wherein, in order to form the at least one flexible diaphragm element (14), a flowable and curable diaphragm material is cast at least in sections onto the reinforcing element (4) coupled to the transducer element (3) in such a way that
the diaphragm element (14) together with the reinforcing element (4) at least partially form the diaphragm unit (5) and
the diaphragm element (14) is spaced from the transducer element (3).

2. The method according to the preceding claim, **characterized in that** the at least one transducer element (3) is coupled to the at least one reinforcing element (4) and the diaphragm element (14) is then cast on.

3. The method according to one or more of the preceding claims, **characterized in that** the at least one transducer element (3) is arranged in an accommodation space (7) of a dam arrangement (6) such that the transducer element (3) and the reinforcing element (4) are completely surrounded by the dam arrangement (6).

4. The method according to the preceding claim 3, **characterized in that** the at least one diaphragm element (14) is cast onto the dam arrangement (6) and/or
the at least one diaphragm element (14) is arranged between the reinforcing element (4) and the dam arrangement (6).

5. The method according to one or more of the preceding claims, **characterized in that** the diaphragm element (14) is cast onto a circumferential side (17) of the reinforcing element (4).

6. The method according to one or more of the preceding claims 3 to 5, **characterized in that** the dam arrangement (6) and the reinforcing element (4) are arranged with respect to one another in such a way that the reinforcing element (4) is spaced from the dam arrangement (6).

7. The method according to one or more of the preceding claims 3 to 6, **characterized in that**, in order to form the at least one diaphragm element (14), the diaphragm material is cast into a diaphragm volume (13) which adjoins the reinforcing element (4) in a transverse direction oriented transversely with respect to the reciprocation axis (H).

8. The method according to one or more of the preceding claims, **characterized in that** at least one pouring opening (18) is formed in the support element (2) such that the diaphragm material can be cast in through the pouring opening (18).

9. The method according to one or more of the preceding claims, **characterized in that** the reinforcing element (4) is placed on an auxiliary element (23) and the diaphragm material is cast in from the direction of the support element (2).

10. A MEMS transducer unit (1) for transducing deflections into electrical signals and/or electrical signals into deflections,
which is formed by means of a method according to one or more of the preceding claims,
comprising a support element (2),
at least one transducer element (3) arranged on the support element (2), and
comprising a diaphragm unit (5) which is coupled to the transducer element (3) and which is formed at least partially by a reinforcing element (4) and a flexible diaphragm element (14),
wherein a coupling element (9) is arranged between the transducer element (3) and the reinforcing element (4) and spaces the transducer element (3) from the reinforcing element (4),
wherein the reinforcing element (4) is coupled to the transducer element (3), and
wherein the flexible diaphragm element (14) made of a diaphragm material is cast on the reinforcing element (4) at least in sections in such a way that
the reinforcing element (4) together with the diaphragm element (3) at least partially form the diaphragm unit (5) and
the diaphragm element (14) is spaced from the transducer element (3).

## Revendications

1. Procédé pour fabriquer une unité de transducteur MEMS (1) pour convertir des signaux électriques en déviations et/ou des déviations en signaux électriques,
dans lequel un élément de transducteur (3) est couplé à une unité de membrane (5) déflectible le long d'un axe de levage (H), qui est formée au moins en partie par un élément de renforcement (4) et un élément de membrane flexible (14),
dans lequel l'au moins un élément de transducteur (3) est disposé sur un élément de support (2),
dans lequel un élément de couplage (9) est disposé entre l'élément de transducteur (3) et l'élément de renforcement (4), qui écarte l'élément de transducteur (3) de l'élément de renforcement (4),
dans lequel, pour former l'au moins un élément de membrane flexible (14), un matériau de membrane fluide et durcissable est coulé au moins en partie sur l'élément de renforcement (4) couplé à l'élément de transducteur (3) de telle sorte que
l'élément de membrane (14) conjointement avec l'élément de renforcement (4) forment au moins en partie l'unité de membrane (5) et l'élément de membrane (14) est écarté de l'élément de transducteur (3).

2. Procédé selon la revendication précédente, **caractérisé en ce que** l'au moins un élément de transducteur (3) est couplé à l'au moins un élément de renforcement (4) et ensuite l'élément de membrane (14) est coulé.

3. Procédé selon l'une ou plusieurs des revendications précédentes, **caractérisé en ce que** l'au moins un élément de transducteur (3) est disposé dans un espace de réception (7) d'un agencement de barrage (6) de sorte que l'élément de transducteur (3) et l'élément de renforcement (4) sont entièrement bordés par l'agencement de barrage (6).

4. Procédé selon la revendication précédente 3, **caractérisé en ce que** l'au moins un élément de membrane (14) est coulé sur l'agencement de barrage (6) et/ou
l'au moins un élément de membrane (14) est disposé entre l'élément de renforcement (4) et l'agencement de barrage (6).

5. Procédé selon l'une ou plusieurs des revendications précédentes, **caractérisé en ce que** l'élément de membrane (14) est coulé sur un côté périphérique (17) de l'élément de renforcement (4).

6. Procédé selon l'une ou plusieurs des revendications précédentes 3 à 5, **caractérisé en ce que** l'agencement de barrage (6) et l'élément de renforcement (4) sont disposés l'un par rapport à l'autre de telle sorte que l'élément de renforcement (4) est écarté de l'agencement de barrage (6).

7. Procédé selon l'une ou plusieurs des revendications précédentes 3 à 6, **caractérisé en ce que** le matériau de membrane pour former l'au moins un élément de membrane (14) est coulé dans un volume de membrane (13) qui est adjacent à l'élément de renforcement (4) dans une direction transversale orientée transversalement à l'axe de levage (H).

8. Procédé selon l'une ou plusieurs des revendications précédentes, **caractérisé en ce qu'**au moins une ouverture de coulée (18) est formée dans l'élément de support (2) de sorte que le matériau de membrane peut être coulé à travers l'ouverture de coulée (18).

9. Procédé selon l'une ou plusieurs des revendications précédentes, **caractérisé en ce que** l'élément de renforcement (4) est placé sur un élément auxiliaire (23) et le matériau de membrane est coulé depuis la direction de l'élément de support (2).

10. Unité de transducteur MEMS (1) pour convertir des déviations en signaux électriques et/ou des signaux électriques en déviations,
qui est formée au moyen d'un procédé selon l'une ou plusieurs des revendications précédentes,
comprenant un élément de support (2),
au moins un élément de transducteur (3) disposé sur l'élément de support (2) et
comprenant une unité de membrane (5) couplée à l'élément de transducteur (3), qui est formée au moins en partie par un élément de renforcement (4) et un élément de membrane flexible (14),
dans lequel un élément de couplage (9) est disposé entre l'élément de transducteur (3) et l'élément de renforcement (4), qui écarte l'élément de transducteur (3) de l'élément de renforcement (4),
dans lequel l'élément de renforcement (4) est couplé à l'élément de transducteur (3) et
dans lequel l'élément de membrane flexible (14) en un matériau de membrane est coulé au moins en partie sur l'élément de renforcement (4) de telle sorte que
l'élément de renforcement (4) conjointement avec l'élément de membrane (3) forment au moins en partie l'unité de membrane (5) et l'élément de membrane (14) est écarté de l'élément de transducteur (3).
